# EUROPEAN PATENT APPLICATION

(11) **EP 4 734 265 A1**
(43) Date of publication of application: **29.04.2026**
(21) Application number: 25210419.5
(22) Date of filing: 22.10.2025
(51) Int. Cl.: H01M 50/519, H01M 10/42, H01M 10/48

(54) **BUS BAR ASSEMBLY AND BATTERY MODULE INCLUDING THE BUS BAR ASSEMBLY**

(30) Priority: 22.10.2024 KR 20240145012
(71) Applicant: SAMSUNG SDI CO., LTD., Yongin-si, Gyeonggi-do 17084 (KR)
(72) Inventor: KWON, Young Hwan, 16678 Suwon-si, Gyeonggi-do (KR)
(74) Representative: Gulde & Partner

(57) **Abstract**

A bus bar assembly (2000) includes a first circuit board (2100) that includes a first circuit (2120) on at least one surface of the first circuit board (2100). A second circuit board (2200) is provided on a surface of the first circuit board (2100) and electrically connected to the first circuit board (2100). A second circuit is printed on two surfaces of the second circuit board (2200).

## Description

### BACKGROUND

### 1. Field of the Disclosure

The present disclosure relates to a bus bar assembly and a battery module including the bus bar assembly.

### 2. Discussion of Related Art

The demand for secondary batteries with high energy density and high capacity is rapidly increasing with the proliferation of electronic devices and electrically powered products such as mobile phones, notebook computers, electric vehicles, and the like. Accordingly, research and development for improving the performance of lithium secondary batteries is being actively conducted.

A lithium secondary battery includes a positive electrode and a negative electrode each including an active material capable of intercalating and deintercalating lithium ions, and an electrolyte. Such a battery produces electrical energy due to oxidation and reduction reactions when lithium ions are intercalated/deintercalated into/from the positive electrode and the negative electrode.

Secondary batteries are used for powering or storing energy not only in small devices such as portable electronic devices, but also in medium and large devices such as electric vehicles and energy storage systems (ESS). In the medium and large devices, a plurality of battery cells are connected to form a battery module to enhance the output and capacity of the system.

In a battery module, a sensing module for measuring the temperature and voltage of the battery cell is mounted to reduce the risk of explosion due to overheating and take protective actions. A communication module is also provided to transmit information measured from the sensing module.

The information disclosed in this section is only for improving understanding of the present disclosure and may include information that does not constitute prior art.

### SUMMARY OF THE DISCLOSURE

The present disclosure is directed to providing a bus bar assembly and/or a battery module to which a flexible die-cut circuit (FDC) is applied. The present disclosure is also directed to providing a method in which soldering of an aluminum pattern is possible during the production of a bus bar assembly and/or a battery module. The present disclosure is further directed to providing a bus bar assembly and/or a battery module including a double-sided circuit.

However, technical problems to be solved by the present disclosure are not limited to the above-described problems, and other problems solved by the present disclosure that are not mentioned will be clearly understood by those skilled in the art from the description below.

A bus bar assembly according to an aspect of the present disclosure includes a first circuit board including a first circuit on at least one surface of the first circuit board, and a second circuit board provided on a surface of the first circuit board and electrically connected to the first circuit board, wherein a second circuit is printed on two surfaces of the second circuit board.

A battery module according to another aspect of the present disclosure includes a housing body, a plurality of battery cells accommodated in the housing body, and a bus bar assembly in the housing body. The bus bar assembly is configured to collect operation information from the battery cells. The bus bar assembly includes a first circuit board including a first circuit on at least one surface of the first circuit board, and a second circuit board provided on a surface of the first circuit board and electrically connected to the first circuit board, and a second circuit is printed on two surfaces of the second circuit board.

Hence, by stacking circuit boards and interconnecting circuits of one of the circuit boards and the other one of the circuit boards, an installation space required for electronic parts in the battery module is reduced.

Possible embodiments of the bus bar assembly that may be combined as desired are presented in the following.

According to a possible embodiment of the bus bar assembly, the first circuit board includes an insulating layer and a metal layer. The metal layer may be provided on the insulating layer. A portion of the metal layer may be cut to form the first circuit. An advantage of this embodiment may be that the metal layer can be readily contacted.

According to a possible embodiment of the bus bar assembly, the metal layer includes at least one of aluminum (Al) and copper (Cu). An advantage of this embodiment may be that the metal layer can be formed easily.

According to a possible embodiment of the bus bar assembly, the first circuit has a larger ratio of an upper length to a lower length than the second circuit. An advantage of this embodiment may be that interconnection of the first and second circuits can be facilitated.

According to a possible embodiment of the bus bar assembly, as viewed from above, the second circuit board is formed with a narrower area than the first circuit board. Viewed from above may mean viewed in a direction perpendicular to a plane in which the first circuit board or the second circuit board extend. An advantage of this embodiment may be that interconnection of the first and second circuits can be facilitated.

According to a possible embodiment of the bus bar assembly, the second circuit board includes an insulating layer on which the second circuit is printed. The second circuit may include an upper circuit printed on a first surface of the second insulating layer and connected to the first circuit. The second circuit may include a lower circuit printed on a second surface of the second insulating layer and connected to the upper circuit. An advantage of this embodiment may be that circuit density may be improved, thereby further reducing installation space requirements.

According to a possible embodiment of the bus bar assembly, the second circuit board includes a through hole that is formed through the insulating layer. The through hole may connect the lower circuit and the upper circuit. An advantage of this embodiment may be that the interconnection of the lower circuit and the upper circuit is facilitated without requiring installation space for interconnecting parts.

According to a possible embodiment of the bus bar assembly, the second circuit board is connected to the first circuit and changes a direction of the first circuit. An advantage of this embodiment may be that installation space is used more efficiently.

According to a possible embodiment of the bus bar assembly, the first circuit includes an exposed region. The bus bar assembly may further include a solder that connects the first circuit and the second circuit through the exposed region. An advantage of this embodiment may be that providing the exposed region for interconnecting the first circuit and the second circuit may facilitate the interconnection of the first circuit and the second circuit in a space saving manner.

According to a possible embodiment of the bus bar assembly, the first circuit board further includes a plating layer. The plating layer may be coated on the exposed region to connect the solder and the first circuit. An advantage of this embodiment may be that providing the plating layer may improve electrical connection to the solder.

Possible embodiments of the battery module that may be combined as desired are presented in the following.

According to at least one possible embodiment of the battery module, the bus bar assembly may correspond to at least one of the embodiments of the bus bar assembly mentioned above.

According to a possible embodiment, the bus bar assembly is connected to at least a portion of the plurality of battery cells. The bus bar assembly may sense at least one of a temperature and a voltage of the battery cells. An advantage of this embodiment may be the intended function of at some of the battery cells can be monitored in a space saving manner.

### BRIEF DESCRIPTION OF THE DRAWINGS

The drawings illustrate preferred embodiments of the present disclosure and, together with the detailed description below, serve to further convey the technical ideas of the present disclosure. The present disclosure should not be construed as being limited to embodiments depicted in the drawings.
FIG. 1 is an exploded perspective view of a battery module according to an embodiment of the present disclosure;
FIG. 2 is a perspective view of a battery cell according to an embodiment of the present disclosure;
FIG. 3 is a cross-sectional view of the battery cell according to an embodiment of the present disclosure;
FIG. 4 illustrates a bus bar assembly according to an embodiment of the present disclosure;
FIG. 5 is an enlarged view of a first circuit board and a second circuit board according to an embodiment of the present disclosure; and
FIG. 6 is an enlarged cross-sectional view of region B taken along line A-A' in FIG. 5 according to an embodiment of the present disclosure.

### DETAILED DESCRIPTION OF EXEMPLARY EMBODIMENTS

Hereinafter, embodiments of the present disclosure will be described in detail with reference to the accompanying drawings. The terms and words used in the present specification and claims should not be construed as being limited to their usual or dictionary meanings and should be interpreted as meanings and concepts consistent with the proposed technical disclosure of the present disclosure based on the principle that the inventor may appropriately define the concept of terms to describe his/her invention in the best way. Accordingly, since the embodiments disclosed in the present specification and configurations shown in the drawings are only some of the most preferable embodiments of the present disclosure and do not represent the entire technical disclosure of the present disclosure, it should be understood that various modifications are possible at the time of filing the present application.

When used in the present specification, "comprise or include" and/or "comprising or including" specify the presence of mentioned shapes, numbers, steps, operations, members, elements and/or groups thereof, and do not exclude the presence or addition of one or more other shapes, numbers, steps, operations, members, elements and/or groups thereof.

In order to help understanding of the present disclosure, the accompanying drawings are not drawn to actual scale and the sizes of some components may be exaggerated. In addition, the same reference numerals may be given to the same components in different embodiments.

Stating that two objects for comparison are 'the same' means that that the two objects are 'substantially the same.' Accordingly, 'substantially the same' may include a deviation considered to be a low level in the art, for example, a deviation within 5%. Further, uniformity of a parameter in a certain area may mean uniformity from an average perspective.

Although first, second, and the like are used to describe various components, these components are not limited by these terms. These terms are only used to distinguish one component from another component, and a first component may also be a second component unless otherwise stated.

Throughout the specification, unless otherwise stated, each component may be singular or plural.

Disposition of an arbitrary component at "an upper portion (or a lower portion)" of a component or "on (or under)" the component means that another component may be interposed between the component and the arbitrary component disposed on (or under) the component or the arbitrary component may be disposed in contact with an upper surface (or a lower surface) of the component.

Further, when it is disclosed that a certain component is "on," "connected to," or "coupled to" another component, it should be understood that the components may be directly connected or coupled to each other, but another component may be "interposed" between the components, or the components may be "connected," "coupled," or "linked" through another component.

As used in the present specification, the term "and/or" includes any one or more and all combinations of the related listed items. Further, when embodiments of the present disclosure are described, the use of "may" relates to "one or more embodiments of the present disclosure." The term such as "one or more" before a list of elements modifies an entire list of the elements and does not modify individual elements in the list.

Throughout the specification, "A and/or B" means to A, B, or A and B unless otherwise stated, and "C to D" means greater than or equal to C and less than or equal to D unless otherwise specified.

When phrases such as "at least one of A, B, and C," "at least one of A, B, or C," "at least one selected from group A, B, and C," or "at least one selected from A, B, and C" are used to specify a list of elements A, B, and C, the phrases may refer to any one of all suitable combinations.

The term "use" may be considered to be synonymous with the term "utilize." As used in the present specification, the terms "substantially," "about," and other similar terms are used as terms of approximation rather than terms of degrees, and are intended to consider an inherent variation in measured or calculated values to be recognized by those skilled in the art.

Although the terms "first," "second," "third," and the like may be used in the present specification to describe various elements, components, regions, layers and/or sections, these elements, components, regions, layers and/or sections should not be limited by these terms. These terms are used only to distinguish one element, component, region, drawing layer, or section from another element, component, region, drawing layer, or section. Accordingly, a first element, component, region, layer, or section to be described below may be referred to a second element, component, region, layer, or section without departing from the teachings of the present disclosure.

Spatially related terms such as "beneath," "below," "lower," "above," and "upper" are used for easy description of the relationship of one element or feature to another element or feature shown in the drawings. These spatially related terms are provided for easy understanding of the present disclosure according to various process states or usage states of the present disclosure and are not intended to limit the present disclosure. For example, when the elements or features in the drawings are reversed, an element described as "lower" or "below" "becomes "upper" or "above." Accordingly, "below" is a concept encompassing "above" or "below."

The terms used in the present specification is intended to describe the embodiments of the present disclosure and is not intended to limit the present disclosure.

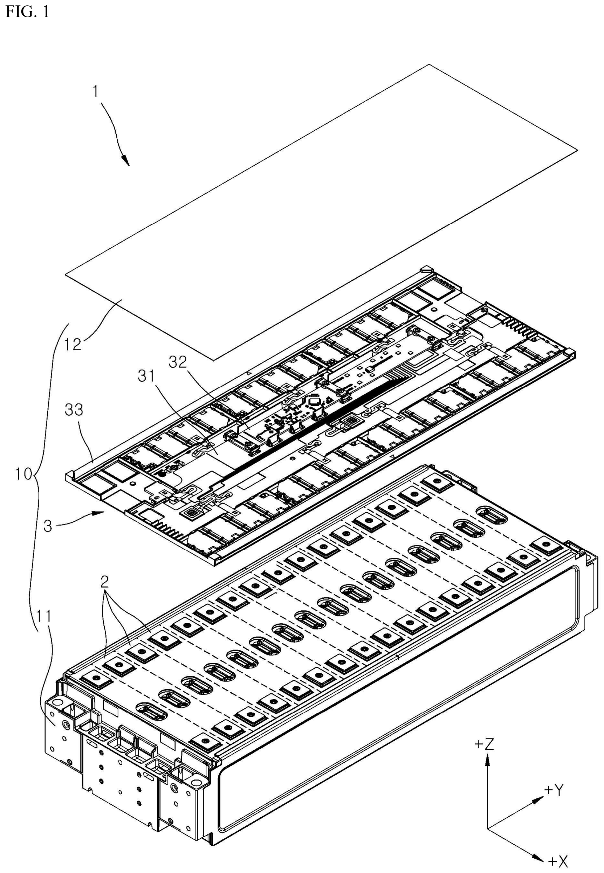

FIG. 1 is an exploded perspective view of a battery module according to one embodiment of the present disclosure. Referring to FIG. 1, a battery module 1 according to the embodiment includes a housing 10, battery cells 2, and a bus bar assembly 3.

The housing 10 may include a housing body 11 and a housing cover 12. The housing body 11 may form an exterior of the battery module 1 and support the battery cells 2 and the bus bar assembly 3. The housing body 11 may be box shaped with an open interior and an open upper side. As alternatives to the rectangular shape shown in FIG. 1, the cross-sectional shape of the housing body 11 may be configured in various ways depending on the number and shape of the battery cells 2.

The housing cover 12 which opens and closes the inner space of the housing body 11 may be disposed at the open side of the housing body 11. The housing cover 12 may be a flat plate that is disposed to face an upper side of the housing body 11. The housing cover 12 may be coupled to the housing body 11 by various types of coupling methods such as welding, bolting, and the like.

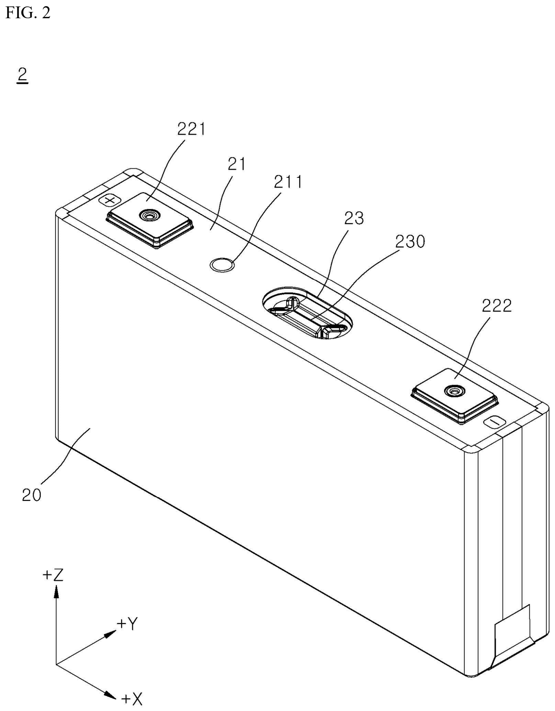

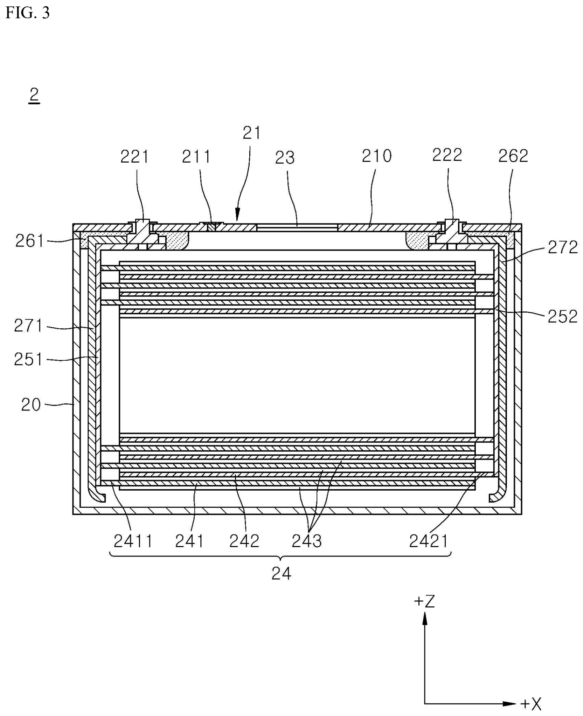

The battery cells 2 may function as unit structures that store and supply power in the battery module 1. The battery cells will be described in detail below with reference to FIGS. 2 and 3.

The bus bar assembly 3 may detect state and/or operation information of the battery cells 2 and transmit the state and/or operation information of the battery cells 2 to a battery management system (BMS).

The bus bar assembly 3 may include a sensing module 31, a communication module 32, and a bus bar holder 33. The sensing module 31 may detect a temperature, a voltage, a current, and the like of the battery cells 2, and the detected information may be transmitted to the communication module 32. The bus bar holder 33 may disposed on the battery cell 2 and support the sensing module 31 and the communication module 32.

FIG. 2 is a perspective view of a battery cell according to an embodiment of the present disclosure. FIG. 3 is a cross-sectional view of a battery cell according to an embodiment of the present disclosure.

Referring to FIGS. 2 and 3, the battery cell 2 may include at least one electrode assembly 24 including a positive electrode 241 and a negative electrode 242. An insulator in the form of a separator 243 may be positioned between the positive and negative electrodes 241 and 241.The electrode assembly 24 is accommodated in a case 20, and a cap assembly 21 is coupled to case 20 to close an opening into the case 20.

Hereinafter, an example in which the battery cell 2 is a prismatic lithium-ion secondary battery will be described. However, the present disclosure is not limited to such a battery configuration. In other embodiments, the battery cell 2 may be, for example, a lithium polymer battery or cylindrical battery.

The electrode assembly 24 may have a jelly roll shape in which the positive electrode 241 and the negative electrode 242 are wound with the insulative separator 243 interposed between the positive and negative electrodes 241 and 242. However, the present disclosure is not limited to such a configuration. In other embodiments, the electrode assembly 24 may be formed as a structure in which the positive electrode 241 and the negative electrode 242 are a plurality of sheets that are alternately stacked with the separator 243 between each pair of the positive and negative electrodes.

The positive electrode 241 and the negative electrode 242 may include a coated portion which is a region where an active material is applied on a current collector formed of a thin metal foil. The electrodes 241 and 242 may also include uncoated portions 2411 and 2421 where the active material is not provided.

The case 20 may form the exterior of the battery cell 2 and may provide a space in which the electrode assembly 24 is accommodated. The case 20 according to the embodiment may be a rectangular parallelepiped shape with an open interior and one open side. The case 20 may be formed of a conductive metal such as aluminum, an aluminum alloy, or nickel-plated steel.

The cap assembly 21 may be coupled to and seal the case 20. The cap assembly 21 may include a cap plate 210 that covers the opening of the case 20. The cap plate 210 may be formed of a conductive material. A positive terminal 221 and a negative terminal 222 electrically connected to the positive electrode 241 and the negative electrode 242 may extend through the cap plate 210 and protrude outward. The outer surfaces of the positive terminal 221 and the negative terminal 222 protruding outward may be threaded and may be fixed to the cap plate 210 with a nut. However, the present disclosure is not limited thereto. For example, in other embodiments, the positive terminal 221 and the negative terminal 222 may be formed in a rivet structure and may be riveted or welded to the cap plate 210.

An electrolyte inlet 211 in which a sealing stopper may be installed may be formed in the cap plate 210. A vent portion 23 formed with a notch 230 may be formed in the cap plate 210, with the vent portion 23 being configured to open when an internal pressure of the case 20 increases.

The positive terminal 221 and the negative terminal 222 may be electrically connected to a first current collector 251 and a second current collector 252 joined to a positive uncoated portion 2411 or a negative uncoated portion 2421, respectively, by welding. However, the present disclosure is not limited thereto, and the positive terminal 221 and the negative terminal 222 may be integrally joined to the first and second current collectors 251 and 252.

An insulating member may be provided between the electrode assembly 24 and the cap plate 210. Here, the insulating member may include a first insulating member 261 and a second insulating member 262, and each of the first insulating member 261 and the second insulating member 262 may be positioned between the electrode assembly 24 and the cap plate 210.

One end of a separation member may be face a side surface of the electrode assembly 24 may be positioned between the insulating member 261 and the positive terminal 221 and/or between the insulating member 262 and the negative terminal 222. The separation member may include a first separation member 271 and a second separation member 272.

An end of the first separation member 271 and an end of the second separation member 272 facing a side surface of the electrode assembly 24 may be positioned between the first insulating member 261 and the positive terminal 221 and the second insulating member 262 and the negative terminal 222. The positive terminal 221 and the negative terminal 222 welded to the first current collector 251 and the second current collector 252, respectively, may be coupled to ends of the first insulating member 261, the second insulating member 262, the first separation member 271, and the second separation member 272.

The battery cell 2 may be disposed in the housing body 11such that the cap plate 210 faces the housing cover 12.

Referring again to FIG. 1, plurality of battery cells 2 may be provided in parallel in the housing body 11. For example, the plurality of battery cells 2 may be arranged in the Y-axis as depicted in FIG. 1. The number of battery cells 2 is not limited to the item shown in FIG. 1, and may be designed in various ways depending on a size or the like of the battery module 1.

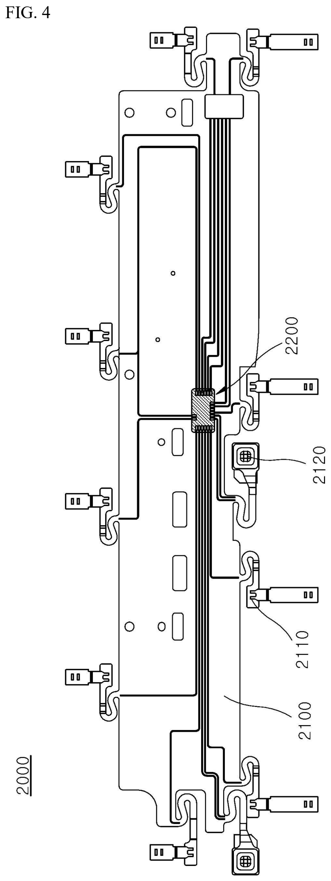

FIG. 4 is a view of a bus bar assembly according to an embodiment of the present disclosure.

As described above, the battery module 1 according to an embodiment of the present disclosure includes the plurality of battery cells 2 and a bus bar assembly 2000 (for example, including the bus bar assembly 3 described above with reference to FIGS. 1 to 3) that manages the plurality of battery cells 2.

The bus bar assembly 2000 manages all or part of the components included in the battery module 1. The bus bar assembly 2000 senses information in all or part of the battery cells 2. The information on the battery cells 2 includes, for example, a current, a voltage, and/or a temperature of the battery cells 2. The bus bar assembly 2000 may transmit this information to the battery management system. Accordingly, the bus bar assembly 2000 may allow the battery management system to determine whether a battery cell 2 is in a charging/discharging state, a heat generation state, a normal state, and the like.

The bus bar assembly 2000 may include a circuit board to obtain the information on the battery cells 2. Generally, the circuit board is made by applying a flexible printed circuit (FPC) process of chemical etching process on a copper foil. However, since the FPC involves an etching process, there are spatial limitations and environmental issues in manufacturing the FPC. Further, the process of manufacturing the FPC may be expensive.

To solve such problems, the bus bar assembly 2000 according to an embodiment of the present disclosure is provided by a method in which a circuit pattern is formed without a chemical etching process. For example, the bus bar assembly 2000 includes a circuit board made by applying a flexible die-cut circuit or flexible die-cut cable (FDC) process. In the FDC process, a circuit and/or a cable is formed by cutting a metal layer using a die. Because metal cut from the metal layer in the FDC process may be recycled, the FDC process may reduce costs and environmental impacts as compared to the FPC process. However, the FDC process has a problem in that it is difficult to form a double-sided circuit.

The bus bar assembly 2000 according to an embodiment of the present disclosure may include a double-sided circuit while having advantages of the FDC process. In embodiments of the present disclosure, a circuit board structure includes two or more layers as the bus bar assembly 2000. As viewed from above, each of the two or more layers may be formed with different areas. Further, each of the two or more layers may include a circuit formed by a different process. For example, each of the two or more layers may include a circuit formed by the FPC process and/or the FDC process.

In some embodiments of the present disclosure, the bus bar assembly 2000 includes a first circuit board 2100 and a second circuit board 2200.

The first circuit board 2100 functions as a main circuit in the bus bar assembly 2000. For example, the first circuit board 2100 may be electrically connected to one or more components included in the battery module 1. and the first circuit board 2100 may detect information about one or more components included in the battery module 1.

The first circuit board 2100 may include various components. For example, the first circuit board 2100 may include at least one of a connector, a metal tab 2110a, and a temperature sensor 3120. In a specific example, the first circuit board 2100 includes the metal tab 2110a, and a number of metal tabs 2110a corresponding to the number of battery cells 2 included in the battery module 1.

Each of the metal tabs 2110a may be joined to the first circuit board 2100. For example, the metal tabs 2110a may be joined to the first circuit board 2100 by soldering. The metal tabs 2110a may include a conductive material to electrically connect the battery cells 2 and the first circuit board 2100. In an example, the metal tabs 2110a may include nickel (Ni).

The first circuit board 2100 is connected to each of the battery cells 2 by the metal tabs 2110a. For example, one of the metal tabs 2110a may be joined to a cell tab extending from one of the battery cells 2 through welding. Alternatively, the metal tab 2110a may be joined to a terminal of the battery cell 2 through welding. In still other embodiments, the metal tabs 2110a may be electrically connected to the battery cells 2 by various methods such as contact, fastening, soldering, and the like.

The first circuit board 2100 may be configured to determine the voltage and/or current of the battery cell 2 through the metal tab 2110a. Alternatively, for example, the first circuit board 2100 may include temperature sensors in a number equal to or less than the number of battery cells 2. The temperature sensors 3120 may be joined to the first circuit board 2100 by various methods such as welding, fastening, soldering, and the like.

The temperature sensors 3120 measure the temperature of all or part of the components included in the battery module 1. For example, each of the temperature sensors 3120 may measure the temperature of one or more battery cells 2. To this end, for example, each of the temperature sensors 3120 may include a thermistor. For example, the temperature sensors 3120 may include a positive temperature coefficient (PTC) thermistor, a negative temperature coefficient (NTC) thermistor, and the like.

The first circuit board 2100 is formed with a first circuit on at least one surface. The first circuit may be formed, for example, using a FDC process. In a specific example, the first circuit board 2100 includes a metal layer, and the first circuit may be formed by cutting the metal layer with a die.

In the first circuit, a ratio of an upper length to a lower length may be relatively large. The first circuit may be formed by cutting using a die that applies a force in a direction perpendicular to the metal layer. Accordingly, the first circuit may be formed so that the lower length and the upper length are the same or nearly the same.

The first circuit may be formed on a cross-section of the first circuit board 2100. Further, the first circuit board 2100 may be made by the FDC process and formed on both surfaces of the first circuit board 2100. In such a case, the first circuit may include an upper circuit and a lower circuit that are not electrically connected. That is, the upper circuit and the lower circuit may perform different roles. But in other embodiments, the upper circuit and the lower circuit may be electrically connected by extending from the first circuit board 2100.

The first circuit is connected to various components included in the first circuit board 2100. For example, the first circuit is electrically connected to the connector, the metal tab 2110a, and/or the temperature sensor 3120. The first circuit may transmit information measured through the components to the communication module 32. and the communication module 32 may transmit this information to the battery management system. Alternatively, the first circuit may be electrically connected to the battery management system and directly transmit the measured information to the battery management system.

As described above, the first circuit board 2100 may be configured with the first circuit formed on one surface. However, when the first circuit is formed on a single surface, the placement of the connector, metal tab, or temperature sensor may require the routing path to be reversed or crossed over. Since such crossovers are difficult on a single layer without excessive detours or reduced creepage/clearance. To solve this problem, the bus bar assembly 2000 may include the second circuit board 2200. The second circuit board 2200 is formed on a surface of the first circuit board 2100. In this case, the surface of the first circuit board 2100 on which the second circuit board 2200 is formed is a surface of the first circuit board 2100 where the first circuit is formed. That is, the second circuit board 2200 may be located on the first circuit.

The second circuit board 2200 is formed on a portion of a surface of the first circuit board 2100. The portion of the surface of the first circuit board 2100 is a region where the routing direction of the first circuit needs to be changed. In this case, the region where the direction needs to be changed may correspond to a portion of the entire first circuit board 2100. Accordingly, when viewed from above, the second circuit board 2200 is formed in less area than the first circuit board 2100.

The second circuit board 2200 includes a second circuit formed, for example, by a FPC process. In some embodiments, the second circuit may be formed by being printed on both surfaces of the second circuit board. In such a case, the second circuit has a relatively small ratio of an upper length to a lower length. For example, the second circuit has a smaller ratio of the upper length to the lower length than the first circuit. In still other embodiments, the second circuit may be formed so that the lower length is greater than the upper length.

With such configurations, embodiments of the present disclosure may improve process efficiency, cost reduction, and environmental impacts by applying the FDC process to the first circuit board 2100 formed with a large area and applying the FPC process to the second circuit board 2200 formed with a small area. However, the method of forming the second circuit is not limited thereto. The second circuit may be formed, for example, through the FDC process. In this case, the second circuit may include an upper circuit and a lower circuit, and the upper circuit and the lower circuit may extend from the second circuit board 2200 and may be electrically connected.

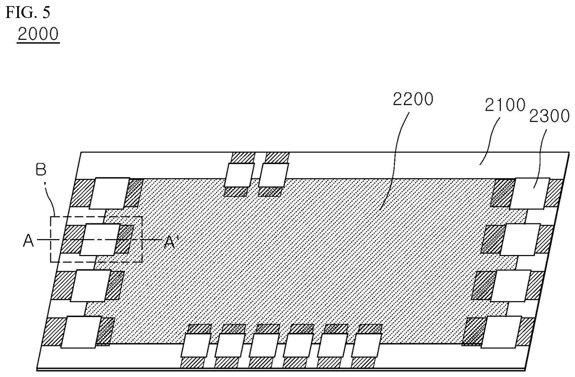

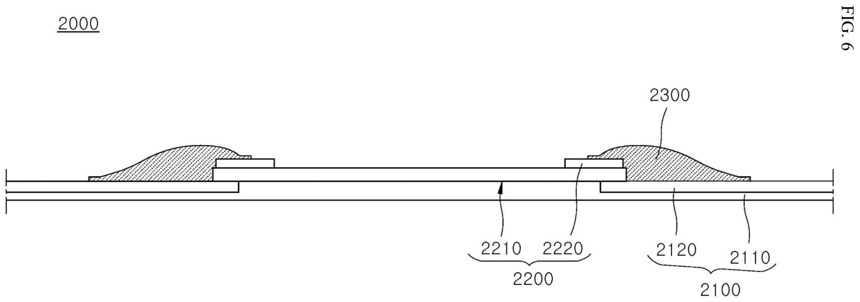

Through the above methods, the bus bar assembly 2000 according to embodiments of the present disclosure may provide an effect such as a double-sided circuit with a low production cost. The structure and/or connection relationship of the first circuit board 2100 and the second circuit board 2200 will be described in more detail below with reference to FIGS 5 and 6.

FIG. 5 is an enlarged view of the first circuit board and the second circuit board according to an embodiment of the present disclosure. FIG. 6 is an enlarged cross-sectional view of region B, taken along line A-A' in FIG. 5.

As described above, the bus bar assembly 2000 according to one embodiment of the present disclosure includes the first circuit board 2100 and the second circuit board 2200. The first circuit board 2100 includes a first insulating layer 2110 and a metal layer forming the first circuit 2120.

The first insulating layer 2110 includes an insulating material. The insulating material includes, for example, polyimide (PI). However, the insulating material is not limited thereto. For example, the insulating material may include at least one of polycarbonate (PC), polyethylene terephthalate (PET), polymethyl methacrylate (PMMA), polypropylene (PP), polyethylene naphthalate (PEN), and a combination thereof.

The metal layer is provided on the insulating layer 2110. A portion of the metal layer is cut to form the first circuit 2120. For example, the metal layer is die cut to form the first circuit 2120.

The first circuit 2120 is electrically connected to all or part of the components included in the battery module 1. Accordingly, the metal layer includes a metal material to provide electrical conductivity. For example, the metal layer may include aluminum (Al). As the first circuit is formed by the FDC process, the metal layer may include relatively inexpensive aluminum. For example, the metal layer may be an aluminum foil. Accordingly, the bus bar assembly 2000 may be inexpensively produced.

When the first circuit 2120 is formed of aluminum, the first circuit 2120 may not be soldered with one or more components included in the first circuit board 2100. To solve this problem, the first circuit 2120 may include a first exposed region (not shown) that is opened and exposed. The first exposed region may correspond, for example, to a region where an electrical connection between the first circuit 2120 and one or more components is required. The first circuit 2120 may include a plating layer (not shown) located on the first exposed region. The plating layer is formed on the first exposed region, for example, by tin plating and/or electroless nickel immersion gold (ENIG) plating. The plating layer allows the first exposed region and the components to be electrically connected. For example, the plating layer allows the first circuit 2120 and one or more components to be electrically connected even when the first circuit 2120 includes a material that may not be soldered. But the metal material included in the metal layer is not limited. For example, the metal layer may include at least one of copper (Cu), silver (Ag), gold (Au), nickel (Ni), and tungsten (W).

The second circuit board 2200 is connected to the first circuit 2120 and changes the routing direction of the first circuit 2120. As shown in FIG. 4, the second circuit board 2200 may serve as a jumper FPC for the first circuit board 2100. Further, the bus bar assembly 2000 may include a includes a solder 2300 that connects the first circuit 2120 and the second circuit 2220.

The second circuit board 2200 may include a second insulating layer 2210 on which the second circuit 2220 is printed. The second insulating layer 2210 includes an insulating material. The insulating material includes, for example, polyimide (PI). However, the insulating material is not limited thereto. In other examples the insulating material may include at least one of polycarbonate (PC), polyethylene terephthalate (PET), polymethyl methacrylate (PMMA), polypropylene (PP), polyethylene naphthalate (PEN), and a combination thereof.

The second circuit 2220 is formed on at least one surface of the second insulating layer 2210. In some examples, the second circuit 2220 may be formed on both surfaces of the second insulating layer 2210.

The second circuit 2220 may include an upper circuit and a lower circuit. The upper circuit is printed on one surface of the second insulating layer 2210. For example, the upper circuit is printed on an upper surface of the second insulating layer 2210. In this configuration, the upper surface of the second insulating layer 2210 is a surface not facing the first circuit 2120.

The upper circuit may be connected to the first circuit. For example, the bus bar assembly 2000 may include the solder 2300 that connects the upper circuit and the first circuit 2120. That is, the solder 2300 may be provided from the upper circuit toward the first circuit 2120. Accordingly, the upper circuit and the first circuit may be electrically connected.

The lower circuit is printed on the other surface of the second insulating layer 2210. That is, the lower circuit is printed on the lower surface of the second insulating layer 2210. In such a configuration, the lower surface of the second insulating layer 2210 is a surface facing the first circuit 2120.

For example, the lower circuit is connected to the upper circuit. As described above, the second circuit may be formed on the second insulating layer 2210 through a FPC process. Accordingly, the second circuit board 2200 may include a through hole (not shown) formed through the second insulating layer 2210. The through hole connects the lower circuit and the upper circuit.

The first circuit 2120 may include a first exposed region (not shown) where a partial region is opened and exposed. The first exposed region is a region where the solder 2300 is provided on the first circuit 2120 to connect the first circuit 2120 and the second circuit 2220. Similarly, the second circuit 2220 may include a second exposed region (not shown) where a partial region is opened and exposed. And the second exposed region is a region where the solder 2300 is provided on the second circuit 2220 to connect the first circuit 2120 and the second circuit 2220.

The solder 2300 is formed on the first exposed region and/or the second exposed region. For example, the solder 2300 is provided on the bus bar assembly 2000 while connecting the first exposed region and the second circuit 2220. In another embodiment, the solder 2300 is provided on the bus bar assembly 2000 while connecting the second exposed region and the first circuit 2120. In still other embodiments, the solder 2300 is formed on the first exposed region and the second exposed region. Accordingly, the first circuit 2120 and the second circuit 2220 may be electrically connected. Further, the first circuit 2120 may have a crossover routing effect by the second circuit 2220.

As described above, the first circuit 2120 may include a material that does not readily receive soldering. For example, the first circuit 2120 may include aluminum. The first circuit board 2100 may further include a plating layer coated on the first exposed region. As described above, this plating layer may be the same as or similar to to the plating layer formed to connect the components and the first circuit. The plating layer is formed on the first exposed region, for example, through tin plating and/or electroless nickel immersion gold (ENIG) plating. The solder 2300 may be electrically connected to the first circuit 2120 through the plating layer.

The bus bar assembly 2000 according to one embodiment of the present can be efficiently and inexpensively processed without harmful environment effects. The bus bar assembly 2000 may provide a pattern cross effect of a double-sided circuit for an FDC film formed with a single side through a jumper FPC film.

Further, the battery module 1 according to one embodiment of the present disclosure including this bus bar assembly 2000 can be efficiently and inexpensively processed without harmful environment effects.

According to the present disclosure, a bus bar assembly and/or a battery module that is efficiently processed is provided.

According to the present disclosure, a bus bar assembly and/or a battery module can be inexpensively produced.

According to the present disclosure, a bus bar assembly and/or a battery module can be produced without harmful environmental effects.

However, technical effects of the present disclosure are not limited to the above-described technical effects, and other technical effects which are not mentioned will be clearly understood by those skilled in the art from the present disclosure.

Although the present disclosure has been described with reference to the embodiments shown in the drawings, these are merely exemplary, and those skill in the art will understand that various modifications are possible.

## Claims

1. A bus bar assembly (2000) comprising:
a first circuit board (2100) including a first circuit (2120) on at least one surface of the first circuit board (2100); and
a second circuit board (2200) provided on a surface of the first circuit board (2100) and electrically connected to the first circuit board (2100),
wherein a second circuit (2220) is printed on two surfaces of the second circuit board (2200).

2. The bus bar assembly (2000) of claim 1, wherein the first circuit board (2100) includes a first insulating layer (2110) and a metal layer provided on the insulating layer; and
wherein a portion of the metal layer is cut to form the first circuit (2120).

3. The bus bar assembly (2000) of claim 2, wherein the metal layer includes at least one of aluminum, and copper.

4. The bus bar assembly (2000) of any of claims 1 to 3, wherein the first circuit (2120) has a larger ratio of an upper length to a lower length than the second circuit (2220).

5. The bus bar assembly (2000) of any of claims 1 to 4, wherein, as viewed from above, the second circuit board (2200) is formed with a narrower area than the first circuit board (2100).

6. The bus bar assembly (2000) of any of claims 1 to 5, wherein the second circuit board (2200) includes a second insulating layer (2210) on which the second circuit (2220) is printed; and
the second circuit (2220) includes an upper circuit printed on a first surface of the second insulating layer (2210) and connected to the first circuit (2120) and a lower circuit printed on a second surface of the second insulating layer (2210) and connected to the upper circuit.

7. The bus bar assembly (2000) of claim 6, wherein the second circuit board (2200) includes a through hole that is formed through the second insulating layer (2210) and connects the lower circuit and the upper circuit.

8. The bus bar assembly (2000) of any of claims 1 to 7, wherein the second circuit board (2200) is connected to the first circuit (2120) and changes a routing direction of the first circuit (2120).

9. The bus bar assembly (2000) of any of claims 1 to 8, wherein the first circuit (2120) includes an exposed region, and
wherein the bus bar assembly (2000) further includes a solder (2300) that connects the first circuit and the second circuit (2220) through the exposed region.

10. The bus bar assembly (2000) of claim 9, wherein the first circuit board (2100) further includes a plating layer coated on the exposed region to connect the solder (2300) and the first circuit.

11. A battery module (1) comprising:
a housing body (11);
a plurality of battery cells (2) accommodated in the housing body (11); and
a bus bar assembly (2000) in the housing body (11), the bus bar assembly (2000) being configured to collect operation information from the battery cells (2),
wherein the bus bar assembly (2000) is the bus bar assembly of any of the previous.

12. The battery module (1) of claim 11, wherein the bus bar assembly (2000) is connected to at least a portion of the plurality of battery cells (2) and senses at least one of a temperature and a voltage of the battery cells (2).
